(19) Europäisches Patentamt
European Patent Office
Office européen des brevets

(11) Publication number: 0 147 946 B1

(12) # EUROPEAN PATENT SPECIFICATION

(45) Date of publication of patent specification: 19.07.89

(51) Int. Cl.$^4$: G 02 B 1/10

(21) Application number: 84308056.5

(22) Date of filing: 21.11.84

(54) **An anti-reflection coating for an infrared transmitting material and laser beam transmitting window or fiber incorporating the same.**

(30) Priority: 12.12.83 JP 232647/83

(43) Date of publication of application: 10.07.85 Bulletin 85/28

(45) Publication of the grant of the patent: 19.07.89 Bulletin 89/29

(84) Designated Contracting States: DE FR GB NL

(56) References cited:
APPLIED OPTICS, vol. 13, no. 9, September 1974, pages 2075-2080, New York, US; J.E. RUDISILL et al.: "Optical coatings for high energy ZnSe laser windows"
OPTICAL ENGINEERING, vol. 18, no. 6, November/December 1979, pages 586-590, Bellingham, US; W.T. BOORD et al.: "Low absorption TlI/KCl/TlI antireflection coatings for KCl surfaces"
APPLIED OPTICS, vol. 17, no. 3, February 1978, pages 447-450, New York, US; A. McLACHLAN: "Two-layer low-absorption antireflection coating for KCl"

(73) Proprietor: SUMITOMO ELECTRIC INDUSTRIES LIMITED
No. 15, Kitahama 5-chome Higashi-ku
Osaka-shi Osaka 541 (JP)

(72) Inventor: Takahashi, Kenichi
c/o Osaka Works Sumitomo Electric Industries, Ltd.
1-3, Shimaya 1-chome Konohana-ku Osaka (JP)
Inventor: Yoshida, Noriyuki
c/o Osaka Works Sumitomo Electric Industries, Ltd.
1-3, Shimaya 1-chome Konohana-ku Osaka (JP)

(74) Representative: Bizley, Richard Edward et al
BOULT, WADE & TENNANT 27 Furnival Street
London EC4A 1PQ (GB)

(56) References cited:
APPLIED OPTICS, vol. 10, no. 12, December 1971, pages 2675-2677, New York, US; G.H. SHERMAN et al.: "Antireflection coatings for silicon in the 2.5-50-mum region"
MICROWAVES, January 1969, pages 68-76, Laser Technology Section, New York, US; F. HORRIGAN et al.: "Windows for high-power lasers"

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

EP 0 147 946 B1

Courier Press, Leamington Spa, England.

## Description

This invention relates to an anti-reflection coating for an infrared transmitting material. More particularly it is concerned with an anti-reflection coating film provided for inhibiting the loss due to reflection in an infrared transmitting material.

Crystalline materials, for example, silver halides such as silver bromide and silver chloride, thallium halides such as KRS-5 and KRS-6 and alkali halides such as cesium iodide and cesium bromide, well known as infrared transmitting materials, have been considered full of promise as $CO_2$ laser beam transmitting window materials or $CO_2$ laser beam transmitting fibers. However, these materials each have a large refractive index at the wavelength of 10.6 µm of µm of a $CO_2$ beam and, accordingly, the incident beam on the surface has a large reflectivity. In Table 1 are shown the refractive indexes and reflectivities of these materials at a wavelength of 10.6 µm of a $CO_2$ laser beam:

TABLE 1

| Materials | Refractive index n | Reflectivity (%) | $\sqrt{n}$ |
|---|---|---|---|
| Silver Bromide | 2.17 | 13.6 | 1.47 |
| Silver Chloride | 1.98 | 10.8 | 1.41 |
| KRS-5* | 2.37 | 16.5 | 1.54 |
| KRS-6* | 2.17 | 13.6 | 1.47 |
| Cesium Iodide | 1.74 | 7.3 | 1.32 |

Note: *) KRS-5 (commercial name): mixed crystal of 45.7% TlBr+54.3% TlI
KRS-6 (commercial name): mixed crystal of 40% TlBr+60% TlCl

These materials have a reflectivity of more than 7. Thus, it is important to reduce the reflective loss and to raise the transmission of a window or fiber. As a method of reducing reflective loss, it is known to form a non-reflective coating film. In a non-reflective coating monolayer, the reflectivity can be made zero by forming on the surface of a substrate a coating film consisting of a material with a refractive index equal to the square root $\sqrt{n}$ of the refractive index n of the substrate to a thickness of $d=\lambda/4n$ wherein $\lambda$ is the wavelength of the transmitted light. The square root $\sqrt{n}$ of the refractive index of the above described materials is in the range of 1.3 to 1.6 as shown in Table 1. As a material transparent in the infrared region and having a refractive index of 1.3 to 1.6, there are potassium bromide, potassium chloride, sodium chloride, sodium fluoride, calcium fluoride and barium fluoride. These materials have reflective indexes and absorption coefficients at a wavelength of 10.6 µm as shown in Table 2:

TABLE 2

| Material | Refractive index | Absorption coefficient $cm^{-1}$ |
|---|---|---|
| Potassium Bromide | 1.53 | $4.2\times10^{-4}$ |
| Potassium Chloride | 1.45 | $1.4\times10^{-4}$ |
| Sodium Chloride | 1.49 | $4.5\times10^{-4}$ |
| Sodium Fluoride | 1.23 | $5\times10^{-2}$ |
| Calcium Fluoride | 1.31 | 3.5 |
| Barium Fluoride | 1.42 | 0.19 |

The reflectivity can be decreased to less than about 3% by forming a film of these materials with a thickness of $\lambda/4n$ of the surface of silver bromide, silver chloride, KRS-5, KRS-6 or cesium iodide. However, calcium fluoride and barium fluoride each have a relatively large absorption coefficient as shown in Table 2 and are not suitable for use in transmitting a high output $CO_2$ laser beam since their coatings tend to be damaged due to absorption. On the other hand, potassium bromide, potassium chloride, sodium chloride and sodium fluoride are all deliquescent, although their absorption coefficients are sufficiently small, so coatings thereof tend to take in moisture from the air and readily decompose and cannot be used as antireflection coatings in stable manner for a long period of time.

The present invention aims to avoid these problems and to provide an anti-reflection coating film capable of decreasing the reflective loss of an infrared transmitting material, specifically to provide an anti-reflection coating capable of preventing an infrared transmitting material such as silver bromide or silver chloride from showing a decrease in the transmission of light.

The invention thus provides an anti-reflection two layer coating for an infrared transmitting material consisting of a crystalline plate or fibre made of silver halides, thallium halides or mixed crystals thereof, characterised in that the inner layer consists of an alkali metal halide and the outer layer consists of silver bromide, silver chloride or mixed crystals thereof, or of lead fluoride, zinc sulfide or zinc selenide, said two layers being provided on the substrate by vacuum vapour deposition methods.

The accompanying drawings are given to illustrate the principle and merits of the present invention in greater detail.

Fig. 1 is a cross-sectional view of one embodiment.

Fig. 2 is a graph showing the conditions under which the reflectivity is zero when providing a substrate with two layers of anti-reflection coatings.

The present invention is based upon the finding that if a coating consisting of a material capable of reducing the reflective loss but having a large solubility in water, such as potassium bromide, potassium chloride, sodium fluoride or sodium chloride, is covered with another coating consisting of an infrared transmitting material stable to water, the inner layer is protected from water and the outer protective layer may be caused to play a role as the outer layer of an anti-reflective double layer but not so as to decrease the anti-reflection effect. Furthermore, the present invention aims at preventing a substrate of silver bromide or silver chloride from a decrease in the transmission of light by protecting the substrate from irradiation by visible rays and ultraviolet rays using a material opaque to visible rays and ultraviolet rays as the outer layer (since silver bromide or silver chloride has a tendency to decompose under irradiation by visible rays and ultraviolet rays).

Accordingly, the present invention provides an anti-reflective coating film for an infrared transmitting material, consisting essentially of an inner layer of an alkali metal halide and an outer layer, provided on the inner layer, of an infrared transmitting material, the inner layer and outer layer being provided on a substrate of the infrared transmitting material and having refractive indexes within the shaded portion of Fig. 2, n representing the refractive index of the substrate. Generally, this anti-reflection coating is provided on the surface of a substrate consisting of an infrared transmitting material such as a silver halide, thallium halide or alkali metal halide, or on the input or output end of an infrared fiber consisting of the same material.

In the case of an anti-reflection coating of double layer structure, in general, it is known that the reflectivity can be zero when the combination of refractive indexes of the inner layer and outer layer is in the range of the shaded portion of Fig. 2 in relation to the refractive index n of the substrate (K. Schuster, Ann, Phys., Sixth Ser. *4* 352 (1949)).

In the present invention, as the substrate there may be used infrared transmitting materials having refractive indexes n as shown in Table 1, $\sqrt{n}$ being in the range of 1.3 to 1.6, for example, silver halides such as silver bromide, silver chloride and mixed crystals thereof, and thallium halides such as thallium chloride, thallium bromide, thallium iodide and mixed crystals thereof.

As the inner layer of the anti-reflection coating provided on such a substrate, there may be used alkali metal halides whose refractive index is in the same range as the above material $\sqrt{n}$, while as the outer layer of the anti-reflection coating there may be used infrared transmitting materials which are stable to water and whose refractive indexes are, in combination with the refractive index of the inner layer, in the range of the shaded portion of Fig. 2, thereby making the reflectivity zero, for example, silver bromide, silver chloride and mixed crystals thereof, thallium chloride, thallium bromide, thallium iodide and mixed crystals thereof, lead fluoride, zinc sulfide, zinc selenide and the like. In addition, germanium, silicon, cadmium telluride and gallium aersenide, which are stable to water and capable of forming a hard film opaque to visible rays and ultraviolet rays, are also suitable for use as a material for the outer layer as set forth above, and when using these materials, the effect of preventing the substrate from decomposition due to visible rays and ultraviolet rays is additionally achieved.

The inner layer and outer layer are provided on a substrate by a vapor deposition method.

The refractive indexes at a wavelength of 10.6 μm and the transmitting wavelength region of outer layer materials are shown in Table 3:

TABLE 3

| Outer layer material | Refractive index | Transmitting wave-length region (μm) |
|---|---|---|
| Silver Bromide | 2.17 | 0.5—30.0 |
| Silver Chloride | 1.98 | 0.4—30.0 |
| KRS-5 | 2.37 | 0.5—40.0 |
| KRS-6 | 2.17 | 2.0—20.0 |
| Lead Fluoride | 2.18 | 0.3—10.0 |
| Zinc Sulfide | 2.20 | 0.5—15 |
| Zinc Selenide | 2.42 | 0.5—25 |
| Germanium | 4.00 | 1.8—22 |
| Silicon | 3.42 | 1.2—13 |
| Cadmium Telluride | 2.67 | 0.91—15 |
| Gallium Arsenide | 3.10 | 1.0—11 |

The materials described in Table 3 are all stable to water or moisture and capable of forming a protective layer for a deliquescent inner layer. Above all, germanium, silicon, cadmium telluride and gallium arsenide do not permit visible rays or ultraviolet rays and when using these materials as an outer layer material in the non-reflective coating for light-sensitive materials such as silver chloride and silver bromide, therefore, a substrate of silver chloride or silver bromide can effectively be protected from decomposition.

As the present coating material having an inner layer and an outer layer, there can be used any combination of the alkali metal halides described in Table 2 and the materials described in Table 3, which have refractive indexes in the range of the shaded portion of Fig. 2.

The following Examples are given in order to illustrate the present invention in detail without limiting the same.

Example 1

Referring to Fig. 1, a silver bromide crystal plate 1 is provided with an anti-reflection coating consisting of inner layer 2 of potassium chloride and an outer layer 3 of silver bromide by a vacuum vapor deposition method. As to the refractive indexes of the substrate and the inner layer and outer layer of the anti-reflection coating, silver bromide has a refractive index n of 2.17, $\sqrt{n}$ being 1.47, so the combination of potassium chloride in inner layer 2 (refractive index at a wavelength of 10.8 μm=1.45) and silver bromide in outer layer 3 (refractive index at a wavelength of 10.6 μm=2.17) is in the range the shaded portion of Fig. 2, thus making the reflectivity zero.

Since inner layer 2 of Fig. 1, consisting of deliquescent potassium chloride, is completely covered with outer layer 3 consisting of silver bromide (which is stable to moisture, the anti-reflection coating is stable to moisture and capable of maintaining the initial non-reflective effect for a long period of time without being decomposing.

The film thickness of each layer can be determined by the following conditions ("Usumaku Kogaku (Thin Film Engineering) Handbook" published by Ohm Co., p-II-297):

$$A+nB-C-nD=O$$

Herein,

$$A=\cos\delta_1\cos\delta_2-\frac{n_2}{n_1}\sin\delta_1\sin\delta_2$$

$$B=i(\frac{1}{n_2}\cos\delta_1\sin\delta_2+\frac{1}{n_1}\sin\delta_1\cos\delta_2)$$

$$C=i(n_1\sin\delta_1\cos\delta_2+n_2\cos\delta_1\sin\delta_2)$$

$$D=\frac{n_1}{n_2}\sin\delta_1\sin\delta_2+\cos\delta_1\cos\delta_2$$

$$(i=\sqrt{-1})$$

$$\delta_1=\frac{2\pi}{\lambda}n_1d_1(n_1,d_1;\text{ refractive index, film thickness of outer layer})$$

$$\delta_2=\frac{2\pi}{\lambda}n_2d_2(n_2,d_2;\text{ refractive index, film thickness of inner layer})$$

($\lambda$=wavelength of light used)

In this Example, the inner layer was provided at a thickness of 1,82 µm and the outer layer, at a thickness of 2.41 µm to give a reflectivity of less than 1%.

For the purpose of examining the effect of this double layer coating, a similar silver bromide crystal plate was coated with only one layer of potassium chloride with a thickness of 1.82 µm by a vacuum vapor deposition method and compared with the above described double layer coating.

In the case of the monolayer coating, the reflectivity was only less than 1% immediately after coating, but after being allowed to stand in humidity of 60% at room temperature for two days the coating film became slightly opaque and the transmission of a $CO_2$ laer beam was lowered from the initial 99% to 80%. In the case of the double layer coating of this Example, in contrast, the transmission of a $CO_2$ laser beam was maintained at the initial value of 99% or more for one month or longer under the same standing conditions.

Example 2

As shown in Fig. 1, the input and output end of a silver bromide crystal fiber 1 is provided with an antireflection coating consisting of an inner layer 2 of potassium chloride and an outer layer 3 of cadmium telluride by vacuum vapor deposition. It is apparent from Fig. 2 that the combination of potassium chloride with cadmium telluride having a reflective index of 2.67 at a wavelength of 10.6 µm, as the outer layer, results in a reflectivity of zero.

In this Example the inner layer was provided at a thickness of 1.82 µm and the outer layer was provided at a thickness of 2.10 µm.

In this Example, not only was the potassium chloride of inner layer 2 protected from decomposition due to water by the cadmium telluride of outer layer 3 in a similar manner to Example 1, but also the silver bromide crystal of substrate fiber 1 was protected from decomposition due to visible rays and ultraviolet rays. That is, cadmium telluride of outer layer 3 has a transmitting wavelength region of 0.9 to 15 µm and is opaque to visible rays and ultraviolet rays, and so incident visible rays or ultravoilet rays are intercepted by outer layer 3 and no decomposition of the silver bromide crystal of substrate fiber 1 occurs attributable to visible rays or ultraviolet rays. Thus, this anti-reflection coating can not only maintain the initial performance against moisture for a long period of time, but also serves as a filter cutting out visible rays and ultraviolet rays from the substrate material.

Comparative data for this Example compared with a monolayer coating of potassium chloride are as follows:

When allowed to stand in a humidity of 60% at room temperature for a long time in an analogous manner to Example 1, the double layer coating of this Example maintained the transmission of a $CO_2$ laser beam at the initial value of 99% or more for one month or longer.

When the input and output end of a silver bromide crystal fiber 1 coated with potassium chloride/cadmium telluride films according to the present invention was allowed to stand in the open air with fine weather for one day, there was no change in the transmission of a $CO_2$ laser beam while in the case of another silver bromide crystal fiber coated with a monolayer coating of potassium chloride for comparison purposes, the silver bromide crystal was sensitized by the visible rays and ultraviolet rays of the sunlight and turned black thus lowering the transmission of a $CO_2$ laser beam to 20% after being allowed to stand for two hours under similar conditions.

Example 3

The stability of anti-reflection coatings for infrared transmitting materials, obtained in an analogous manner to Example 1 except for changing the materials of the substrate, inner layer and outer layer as shown in Table 4, was examined, thus obtaining the results shown in Table 4:

TABLE 4

| Substrate | Inner layer (film thickness) | Outer layer (film thickness) | Stability* to water | Stability** visible rays & ultraviolet rays |
|---|---|---|---|---|
| KRS-5 | NaCl (1.78 µm) | AgCl (2.68 µm) | ○ | |
| | | KRS-5 (2.23 µm) | ○ | |
| | | $PbF_2$ (2.57 µm) | △ | |
| | | Ge (1.3 µm) | ○ | ○ |
| | KBr (1.73 µm) | GaAs (1.7 µm) | ○ | ○ |
| | KCl (1.83 µm) | AgBr (2.41 µm) | ○ | |
| | | ZnS (2.41 µm) | △ | |
| | | Si (1.63 µm) | ○ | ○ |
| | | KRS-6 (2.44 µm) | ○ | |
| | | AgCl (2.68 µm) | ○ | |
| | | KRS-5 (2.23 µm) | ○ | |
| AgBr | KCl (1.83 µm) | Ge (1.3 µm) | ○ | ○ |
| KRS-6 | | GaAs (1.7 µm) | ○ | ○ |
| | | AgBr (2.41 µm) | ○ | |
| | | ZnS (2.41 µm) | △ | |
| | | Si (1.63 µm) | ○ | ○ |
| | | KRS-6 (2.44 µm) | ○ | |
| CsI | NaF (2.2 µm) | Ge (1.3 µm) | ○ | ○ |
| | | GaAs (1.7 µm) | ○ | ○ |
| | | AgCl (2.68 µm) | ○ | |
| | | AgBr (2.41 µm) | ○ | |
| | | ZnS (2.41 µm) | △ | |
| | | Si (1.63 µm) | ○ | ○ |
| | | ZnSe (2.19 µm) | ○ | |

Note:

*) Mark ○ means no change in transmission of $CO_2$ laser beam after standing in humidity of 60% at room temperature for 1 month or longer, (initial transmission: 99% or more)

Mark △ means no change in transmission of $CO_2$ laser beam after standing under same conditions for 1 week or longer, (initial transmission: 99% or more)

**) Mark ○ means no change in transmission of $CO_2$ laser beam after standing in open air with fine weather for 2 hours. (initial transmission: 99% or more).

As illustrated above in detail, an anti-reflection coating for an infrared transmitting material, which is stable to water or moisture and free from deterioration in performance for a long period of time, can be formed according to the present invention and moreover, an anti-reflection coating for an infrared transmitting material can be provided which is capable of intercepting visible rays and ultraviolet rays as a filter thus preventing decomposition of a substrate material.

**Claims**

1. An anti-reflection two layer coating for an infrared transmitting material consisting of a crystalline plate or fibre (1) made of silver halides, thallium halides or mixed crystals thereof, characterised in that the inner layer (2) consists of an alkali metal halide and the outer layer (3) consists of silver bromide, silver chloride or mixed crystals thereof, or of lead fluoride, zinc sulfide or zinc selenide, said two layers (2, 3) being provided on the substrate (1) by vacuum vapour deposition methods.

2. A coating as claimed in claim 1 wherein the substrate material (1) is selected from silver bromide, silver chloride or mixed crystals thereof, thallium chloride, thallium bromide, thallium iodide or mixed crystals thereof.

3. A coating as claimed in claim 1 or claim 2 wherein the alkali metal halide of the inner layer (2) is potassium bromide, potassium chloride, sodium chloride, sodium fluoride, or mixed crystals thereof.

4. A laser beam transmitting window or fiber incorporating a coating as claimed in any one of claims 1 to 3.

**Patentansprüche**

1. Zweilagige Antireflexionsbeschichtung für ein Infrarotstrahlung durchlassendes Material mit einer kristallinischen Platte oder Struktur (1) aus Silber-Halogeniden, Thallium-Halogeniden oder gemischten Kristallen daraus, dadurch gekennzeichnet, daß die innere Schicht (2) aus einem Alkalimetall-Halogenid besteht und die äußere Schicht (3) aus einem Silberbromid, Silberchlorid oder gemischten Kristallen daraus, oder aus Bleifluorid, Zinksulfid oder Zinkselenid, wobei die zwei Schichten (2, 3) auf das Substrat (1) mittels Vakuum-Dampfablagerung aufgebracht sind.

2. Beschichtung nach Anspruch 1, wobei das Substratmaterial (1) ausgewählt ist aus der Gruppe bestehend aus Silberbromid, Silberchlorid oder gemischten Kristallen daraus, Thalliumchlorid, Thalliumbromid, Thalliumiodid oder gemischten Kristallen daraus.

3. Beschichtung nach einem der Ansprüche 1 oder 2, wobei das Alkalimetall-Halogenid der inneren Schicht (2) Kaliumbromid, Kaliumchlorid, Natriumchlorid, Natriumfluorid oder eine Kristellmischung daraus ist.

4. Fenster oder Struktur, welche einen Laserstrahl durchläßt, dadurch gekennzeichnet, daß eine Beschichtung nach einem der Ansprüche 1 oder 3 vorgesehen ist.

**Revendications**

1. Revêtement antireflet an deux couches pour un matériau transmetteur d'infrarouge consistant en une plaque ou fibre cristalline (1) constituée d'halogénures d'argent, d'halogénures de thallium ou de cristaux mixtes de ces halogénures, caractérisé en ce que la couche intérieure (2) consiste en un halogénure de métal alcalin et la couche extérieure (3) consiste en bromure d'argent, en chlorure d'argent ou en cristaux mixtes de ces matières, ou bien en fluorure de plomb, en sulfure de zinc ou en séléniure de zinc, ces deux couches (2, 3) étant produites sur le substrat (1) par des procédés de déposition de vapeur sous vide.

2. Revêtement suivant la revendication 1, dans lequel la matière (1) servant de substrat est choisie entre le bromure d'argent, le chlorure d'argent ou des cristaux mixtes de ces matières, le chlorure de thallium, le bromure de thallium, l'iodure de thallium ou des cristaux mixtes de ces matières.

3. Revêtement suivant la revendication 1 ou la revendication 2, dans lequel l'halogénure de métal alcalin de la couche intérieure (2) est le bromure de potassium, le chlorure de potassium, le chlorure de sodium, le fluorure de sodium ou des cristaux mixtes de ces matières.

4. Fenêtre ou fibre de transmission de faisceau laser renfermant un revêtement suivant l'une quelconque des revendications 1 à 3.

FIG. 1

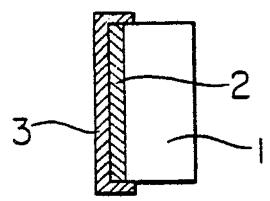
2
3
1

FIG. 2

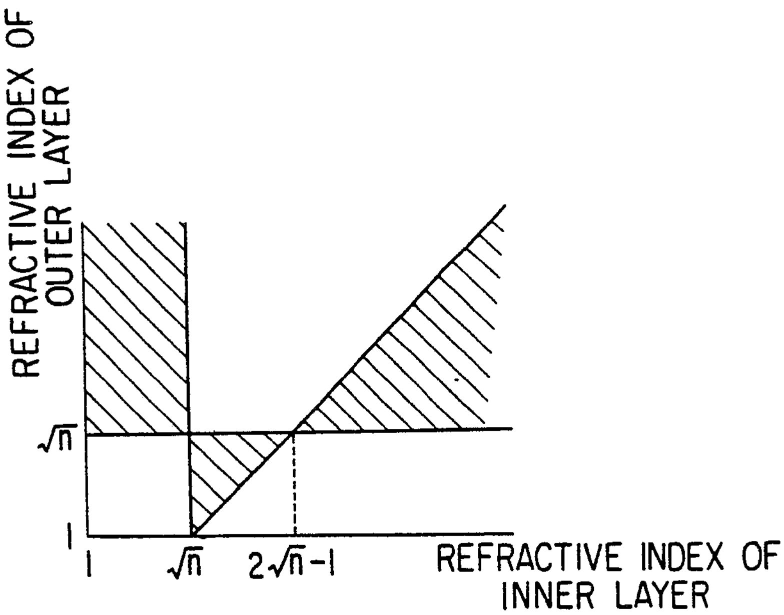
REFRACTIVE INDEX OF OUTER LAYER
√n
1
1
√n
2√n-1
REFRACTIVE INDEX OF INNER LAYER